# EUROPÄISCHE PATENTSCHRIFT

(11) **EP 1 039 334 B1**
(45) Veröffentlichungstag und Bekanntmachung des Hinweises auf die Patenterteilung: **11.04.2007**
(21) Anmeldenummer: 00101476.0
(22) Anmeldetag: 26.01.2000
(51) Int. Cl.: G02F 1/135, C23C 16/50, C23C 16/44, C23C 16/32, C23C 16/02

(54) **Verfahren zum Aufbringen einer lichtblockierenden Schicht zwischen photoleitender Schicht und Spiegel bei der Herstellung eines optisch adressierbaren, ortsauflösenden Lichtmodulators OASLM**
Method of applying a light blocking layer between photoconductive layer and mirror during manufacture of an optically adressable spatial light modulator (OASLM)
Procédé pour appliquer une couche de blocage de la lumière entre une couche photoconductrice et un mirroir lors de la fabrication d'un modulateur spatial de lumière optiquement adressable (OASLM)

(30) Priorität: 23.03.1999 DE 19914112
(43) Veröffentlichungstag der Anmeldung: 27.09.2000
(73) Patentinhaber: Deutsche Telekom AG, 53113 Bonn (DE)
(72) Erfinder: Dultz, Wolfgang, Prof.Dr., 65936 Frankfurt/M. (DE); Haase, Wolfgang, Prof.Dr., 64354 Reinheim (DE); Beresnev, Leonid, Dr., Columbia, MD 21044 (US); Konshina, Elena, Dr., 199155 St. Petersburg (RU); Onokhov, Arkady, Dr., 198097 St. Petersburg (RU)

(56) Entgegenhaltungen:
- EP-A- 0 556 985
- US-A- 5 132 814
- US-A- 5 249 554
- US-A- 5 640 260
- US-A- 5 662 965

## Beschreibung

Das erfindungsgemäße Verfahren betrifft den Bereich von mehrschichtigen Strukturen, die Flüssigkristallschichten enthalten. Speziell handelt es sich um eine Absorptionsschicht für einen optisch adressierbaren, ortsauflösenden Lichtmodulator ,OASLM.

Optisch adressierbare, ortsauflösende Lichtmodulatoren OASLM werden für verschiedene Bereiche der optischen Telekommunikation gebraucht. Als Beispiel sei der Pegelabgleich in WDM-Vielkanalsystemen genannt, wie bei W. P. Beard et al, "AC Liquid Crystal Light Valve", Appl. Phs. Lett.", vol. 22, No.3, 90-92 (1973) beschrieben.

Andere Anwendungen betreffen die lokale Abschwächung von starken Lichtquellen als Blendschutz sowie Anwendungen, um ein Überstrahlen des Bildes in Videokameras, Videobrillen, Pilotbrillen usw. zu verhindern, siehe W. P. Bleha, L. P. Lipton, E. Winere, Opt. Eng., vol 17, No.4ight Valbe", Appl. Phys. Lett", V, Opt. Eng., V, 371-384 (1978)

Besonders wichtig für die optische Parallelverarbeitung von Bildern ist die Umsetzung von optischen, inkohärenten Bildern in den kohärenten Strahlengang des optischen Korrelators. Hierfür werden optisch adressierbare, ortsauflösende Lichtmodulatoren OASMLs eingesetzt, bei denen Schreib- und der Auslesestrahlengang optisch voneinander getrennt sind. Für den Fall, daß das Ausleselicht spektral mit der Empfindlichkeitskurve des Photoleiters überlappt, muß es vollständig vom Schreibstrahlengang getrennt werden, da sonst starke Verluste bei der Empfindlichkeit, der Auflösung und dem Grauwertbereich des OASMLs durch diese parasitäre Beleuchtung auftreten.

Nur in relativ seltenen Fällen ist es möglich, den Schreib- und den Auslesestrahlengang allein durch die spektrale Zusammensetzung von Schreib- und Ausleselicht optisch zu trennen, indem man Photoleiter verwendet, die ausschließlich im blauen Lichtbereich absorbieren, während man zum Auslesen rotes oder infrarotes Licht nimmt.
Keine der üblichen Spiegelschichten aus Metallfilmen oder dielektrischen Filmen haben eine genügend kleine Transmission, um die beiden Strahlengänge zu trennen und das Eindringen des Ausleselichtes in den Photoleiter zu verhindern.

Eine nennenswerte Verbesserung der Lichttrennung läßt sich durch zusätzliche absorbierende Schichten zwischen dem Photoleiter und der Spiegelschicht des Auslesestrahlengangs erreichen. Eine Halbleiterschicht kann als absorbierende Schicht verwendet werden, wenn der Bandabstand kleiner als der des Photoleiters ist.

Aus W. P. Beard et al, "AC Liquid Crystal Light Valve", Appl. Phs. Lett.", vol. 22, No.3, 90-92 (1973),
W. P. Bleha, L. P. Lipton, E. Winere, Opt. Eng., vol 17, No.4ight Valbe", Appl. Phys. Lett", V, Opt. Eng., V, 371-384 (1978) und
U.Efron, J. Grinberg, P. O. Braatz, M. J. Little, P. G. Reif and R. N. Schwarts, "The silicon liquid-crystal light valve", J. Appl. Phys., Vol. 57, No.4, 1356-1368 (1985) ist der Einsatz einer Cadmiumtelluridschicht CdTe als lichtblockierende Schicht bekannt. Beschrieben wurde eine Cadmiumtelluridschicht CdTe von 2µ Dicke, einem Oberflächenwiderstand von 10¹¹ Ω cm und einem Absorptionskoeffizienten nicht kleiner als 10⁵ cm⁻¹ bei 525 nm in Strukturen, die Cadmiumsulfid CdS als Photoleiter verwendeten. Die gleiche Lichtblockierschicht wurde auch zur Eigenschaftsverbesserung von Lichtventilen auf der Basis von Flüssigkristallen mit amorphem Silizium (α-Si) als Photoleiter verwendet. Die CdTe Schicht wurde zwischen dem dielektrischen Spiegel (auf der Basis von Titanoxid) und einer speziellen Haftschicht (zur Verbesserung der Haftung der CdTe am Photoleiter) angebracht. Die Haftschicht bestand aus 4 Lagen:
1.) einem SiO₂-Film, der in Argonatmosphäre aufgebracht wurde,
2.) einem SiO₂-Film, der in einer Argon-Sauerstoffatmosphäre aufgebracht wurde,
3.) einem CdTe-Film, der ebenfalls in einer Argon-Sauerstoffatmosphäre aufgebracht wurde und
4.) einem CdTe-Film, der wiederum in einer Argonatmosphäre aufgebracht wurde.

Amorpher Kohlenstoff α-C und amorpher hydrierter Kohlenstoff α-C:H an sich sind bekannt als dünne Filme mit hoher Lichtabsorption. Diese Stoffe können durch Sputtern oder Verdampfen von Kohlenstoffen oder durch chemische Dampfdeposition CVD mit Kohlenwasserstoffen als Precursor aufgebracht werden, siehe A. V. Balakov, E. A. Konshina, "Methods of production and properties of diamond-like carbon films", Sov. J. Opt. Technol.", Vol.49, No.9, 591-599 (1982) und
A. Bubenzer, B. Dischler, G. Brandt, P. Koidl, "Optical properties of hydrogenated hard carbon thin films", Thin Solid Films, Vol.91, 81-87 (1982).
Für diesen Zweck werden Plasmaentladungen im Radiofrequenzbereich und die Magnetongasentladung verwendet, siehe A. Bubenzer, B. Dischler, A. Nyaiesh, "RF-plasma deposited amorphos hydrogenited hard carbon thin films. Preparation, properties and applications", J. Appl. Phys., Vol.54, 4590-454595 (1983) und
D. R McKenzie, R. C. McPhedran, N. Savvides, "Analysis of films prepared by plasma polymerization of acetylene in a d. c. magnetron", Thin Solid Films, Vol. 108, 247-256 (1983)
Auch direkte Ionenstrahl- und Zweifachstrahl-Deposition sowie Laserabtragung vom Kohlenstofftarget können verwendet werden. Die optischen Konstanten von amorphen Kohlenstoffschichten und amorphen, hydrierten Kohlenstoffschichten hängen charakteristisch von der Deposition und den Parametern des Kondensationsprozesses ab, siehe
F. W. Smith, "Optical constants of a hydrogenated amorphous carbon films", J. Appl. Phys., Vol.55, 764-771 (1984).
Die beschriebenen Kohlenstoff-Schichten werden als Reflexionsschichten bzw. als schützende Schichten in der IR-Optik eingesetzt. Optisch sichtbare Kohlenstoff-Schichten mit einer Absorption im sichtbaren Spektralbereich werden für selektive Solaranwendungen und als kontrastverstärkende Schichten für Kristalldisplays verwendet.
Ein Kohlenstoff enthaltender Film von sehr komplexer Struktur aus Silizium, Germanium und Kohlenstoff ist aus K. Takizawa, T. Fuijii, M. Kawakita, H. Kikuchi, H. Fuijkake, M. Yokozawa, A. Murata and K. Kishi, "Spatial light modulators for projection displays", Applied Optics, Vol. 36, No.23, 5732-5747 (1997) bekannt. Die dort beschriebenen Schichten hatten eine große Dicke von 3,5 µm und mehr, um die notwendige Absorption und den notwendigen Widerstand in einem OASLM auf der Basis von dicken (250 µm) BSO-Photoleiterschichten und polymerdispergierter nematischer Flüssigkristalle zur Verfügung zu stellen.
Für α-Si:H und α-Si:C:H photoleitende Schichten sind diese Blockierungsschichten zu dick, um die grundsätzlichen Parameter des OASLMs optimieren zu können. Ein weiterer Nachteil besteht darin, daß diese komplexen Zusammensetzungen aus Si, Ge und C zu teuer in der Herstellung sind.

Aus US-A-5 132 814 ist ein räumlicher Flüssigkristall-Lichtmodulator mit Mehrschichtfotoleiter bekannt, bei dem unter anderem unter Anwendung eines CVD Verfahrens die photoleitende und die lichtblockierende Schicht in einem Verfahrensschritt aufgebracht werden. Bei dieser Lösung bestehen die lichtblockierenden Schichten immer aus wasserstoffgeladenem Siliziumkarbid mit überschüssigem Silizium. Die lichtblockierenden Eigenschaften derartig strukturierter Schichten sind auf die Absorption von schmalen Wellenlängen-Bandbreiten ausgerichtet.
Das heißt, diese Schichten arbeiten für verschiedenen Bänder des Spektrums als Photoleiter oder als Lichtblockierer.

Das erfindungsgemäße Verfahren ist auf die Entkopplung des Schreib- und Auslesestrahlengangs eines optisch adressierbaren ortsauflösenden Flüssigkeitsmodulators (OASLM) im Reflexionsbetrieb durch Aufbringen einer lichtblockierenden Schicht zwischen Schreib- und Auslesestrahlengang ausgerichtet. Zur Bestimmung und Optimierung der Eigenschaften des Lichtventils soll es möglich sein, während des Verfahrens die spezifischen Widerstände der Schichten und damit die Leitfähigkeit der Schichtenfolge transparente Elektrode ITO- photoleitende Schicht und lichtblockierende Schicht in engen Grenzen gezielt einzustellen. Das Verfahren soll dabei möglichst einfach und kostengünstig zu realisieren sein.

Das Aufbringen der transparenten Elektrode ITO 2 auf das Glas- oder Quarzglassubstrat 1 erfolgt nach bereits bekannten Verfahrensschritten des CVD- Prozesses in einer CVD-Anlage. Die Abscheidung von photoleitender Schicht 3 und lichtblockierender Schicht 4 wird erfindungsgemäß in einem Verfahrensschritt durchgeführt. Zunächst wird auf dem Glas- oder Quarzglassubstrat 1, welches mit der transparenten Elektrode ITO 2 beschichtet ist, in einer Silanatmosphäre eine photoleitende Schicht 3 aus amorphem hydriertem Silizium abgeschieden. Durch kontinuierliches Ersetzen der Silane durch Kohlenwasserstoffe in der Gasatmosphäre der CVD-Anlage setzt sich bei Gleichstromentladungen eine lichtblockierende Schicht 4 auf der photoleitenden Schicht 3 nieder. In Abhängigkeit von der Gaszusammensetzung während des Abscheidungsprozesses wird eine lichtblockierende Schicht 4 aus amorphem Kohlenstoff α-C bzw. amorphem hydriertem Kohlenstoff α-C:H erzeugt. Durch die zeitbezogene kontinuierliche Änderung der Variation der Gaszusammensetzung während des Abscheideprozesses wird dabei sowohl die Stärke der photoleitenden Schicht 3, als auch die Stärke der lichtblockierenden Schicht 4 eingestellt, so daß eine Schichtenfolge mit den gewünschten spezifischen Widerständen entsteht. Das bedeutet, daß der spezifische Widerstand der aus transparenter Elektrode/ITO 2, photoleitender Schicht 3 und lichtblockierender Schicht 4 bestehenden Schichtenfolge sowohl von der jeweiligen Gaszusammensetzung während des Abscheideprozesses, als auch von der Länge des Abscheideprozesses selber abhängig ist. Das Aufbringen des Spiegels 5, der orientierenden Schicht 6 und des Flüssigkristalls 7 erfolgt nach bereits bekannten Verfahrensschritten.
Die als Absorptionsschicht wirkende lichtblockierende Schicht 4 aus amorphem Kohlenstoffbzw. aus amorphem hydrierten Kohlenstoff wird dadurch erzeugt, daß kontinuierlich Azetylen in die aus Argon bestehende Gasatmosphäre der CVD-Anlage eingespeist wird, und daß sich bei Gleichstromentladungen auf der photoleitenden Schicht 3 eine lichtblockierende Schicht 4 aus reinem Kohlenstoff niederschlägt.
Wenn eine Schicht aus Azetylen-Argon nach dem CVD Verfahren in einer Gleichstromentladung niedergeschlagen wird, liegt der spezifische Widerstand der lichtblockierenden Schicht 4 in der Größenordnung von 10⁸ Ohm cm. Desto mehr Azetylen-Anteile die Azetylen-Argon Gasatmosphäre der CVD-Anlage enthält, desto höher wird der spezifische Widerstand der lichtblockierenden Schicht 4. Aus einer reinen Azetylen-Gasatmosphäre abgeschiedene lichtblockierende Kohlenstoff-Schichten α-C:H haben einen spezifischen Widerstand von ca. 10¹² Ohm cm.

Das erfindungsgemäße Verfahren wird anhand von Ausführungsbeispielen näher erläutert. Dabei zeigen:
- Fig. 1:: den Querschnitt der Schichten eines OASLMs entsprechend der hier beschriebenen Erfindung,
- Fig. 2:: die Abhängigkeit des linearen Absorptionskoeffizienten einer lichtblockierenden Schicht von der Dicke der Schicht bei einer Lichtreduktion von 1 : 100 und 1 : 1000,
- Fig. 3:: die spektrale Abhängigkeit des linearen Absorptionskoeffizienten einer amorphen, hydrierten Kohlenstoffschicht α-C:H,
- Fig. 4:: die Transmission einer aus amorphem, hydriertem Kohlenstoff α-C:H bestehenden lichtblockierenden Schicht 4 bei 1 µm Dicke,
- Fig. 5:: die Strom-Spannungscharakteristik U (I) für die Struktur transparente E!ektrode/ ITO 2 + lichtblockierende Schicht 4 aus amorphem, hydriertem Kohlenstoff α-C:H, niedergeschlagen aus einer Azetylen-Argon-Mischung + dielektrischer Spiegel 5 und
- Fig. 6:: die Strom-Spannungscharakteristik U (I) für die Struktur transparente Elektrode ITO 2 + lichtblockierende Schicht 4 aus amorphem, hydriertem Kohlenstoff α-C:H, niedergeschlagen aus einer Azetylen-Atmosphäre + dielektrischer Spiegel 5.

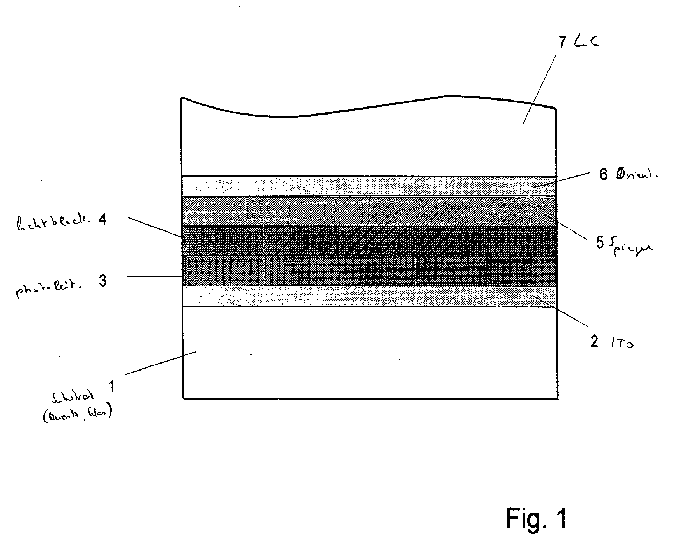

Figur 1 zeigt den Aufbau des optisch adressierten ortsauflösenden Lichtmodulators (OASLM) mit der lichtblockierenden Schicht 4, die entsprechend der Erfindung aus amorphem Kohlenstoff α-C oder amorphem, hydriertem Kohlenstoff α-C:H besteht. Das Bauelement enthält außerdem das Glas- oder Quarzglassubstrat 1, die transparente Elektrode 2 (ITO), die photoleitende Schicht 3, den dielektrischen Spiegel 5 und die orientierende Schicht 6 für den Flüssigkristall 7.

Die lichtblockierende Schicht 4 liegt zwischen der photoleitenden Schicht 3 und dem dielektrischen Spiegel 5. Sie erfüllt die Aufgabe, die optischen Strahlengänge oberhalb und unterhalb der lichtblockierenden Schicht 4 zu entkoppeln und verbessert damit die Eigenschaften des OASLMs. Reine Kohlenstoffilme aus α-C Kohlenstoffbzw. α-C:H Kohlenstoff sind im sichtbaren Spektralbereich hochabsorbierend. Das Ausleselicht, das vom Flüssigkristall 7 her auf den Spiegel 5 fällt, wird, soweit es nicht reflektiert wird, in der lichtblockierenden Schicht 4 absorbiert und damit von der photoleitenden Schicht 3 ferngehalten.

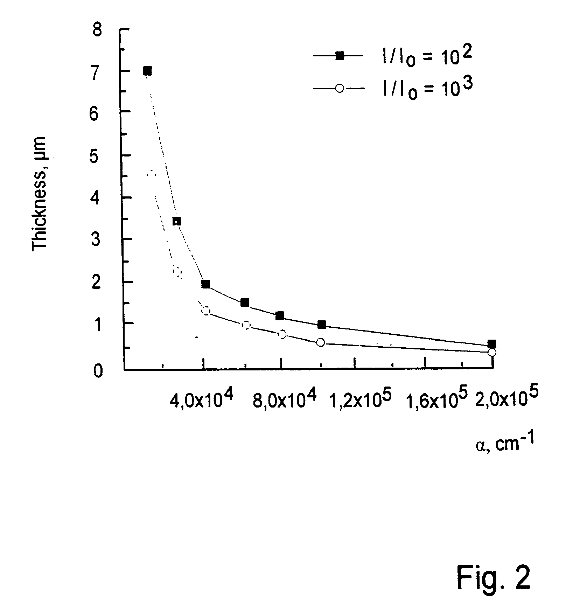

Figur 2 zeigt anhand eines Diagramms, daß zur 100-fachen Unterdrückung des Lichtes zwischen der photoleitenden Schicht 3 und dem dielektrischen Spiegel 5 des OASLMs eine lichtblockierende Schicht 4 mit der Dicke von 1 µm und einem Absorptionskoeffizienten α von nicht weniger als 5 ˙ 10⁴ cm⁻¹ benötigt wird.
Für eine 1000fache Unterdrückung des Lichtes sollte der Absorptionskoeffizient α nicht kleiner als 7 ˙ 10⁴ cm⁻¹ sein.
Für eine 2 µm dicke lichtblockierende Schicht 4 sollte der Absorptionskoeffizient α oberhalb 3 ˙ 10⁴ (4 ˙ 10⁴) cm⁻¹ liegen.

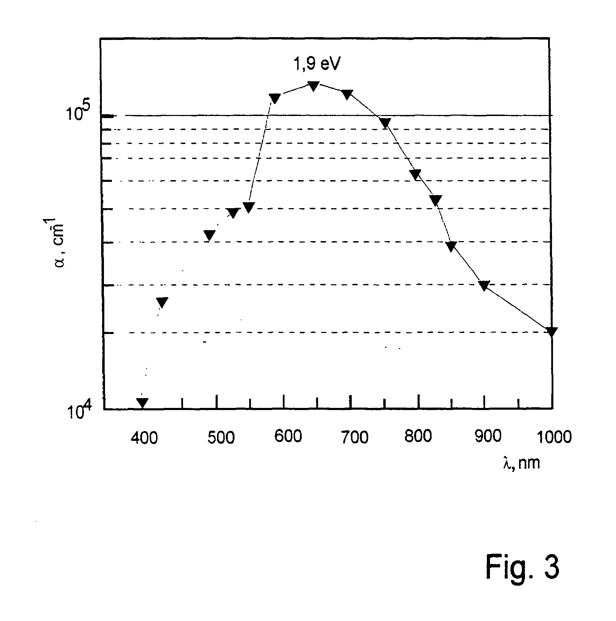

Figur 3 zeigt die spektrale Abhängigkeit des linearen Absorptionskoeffizienten α für eine aus amorphem, hydriertem Kohlenstoff α-C:H bestehende lichtblockierende Schicht 4. Man sieht, daß der Absorptionskoeffizient α den Wert von 1 ˙ 10⁴ cm⁻¹ im Bereich von einer Wellenlänge λ = 400 nm bis 1000 nm übersteigt und bei einer Wellenlänge von λ = 650 nm einen Absorptionskoeffizienten α von 2 ˙ 10⁵ cm⁻¹ erreicht.

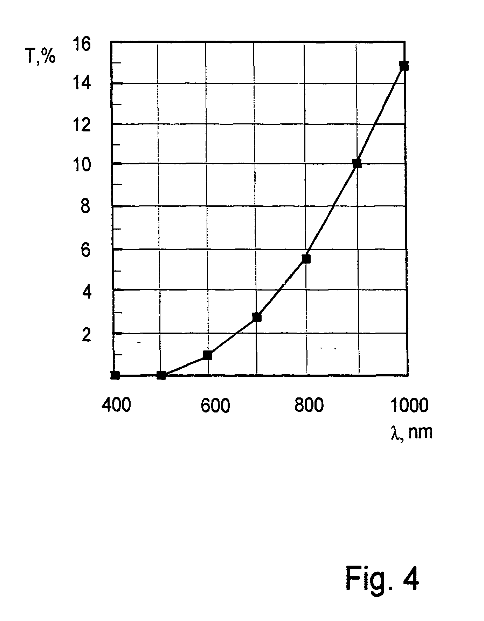

Figur 4 zeigt die Transmission einer lichtblockierenden Schicht 4 aus amorphem, hydriertem Kohlenstoff α-C:H von etwa 1 µm Dicke. Diese lichtblockierende Schicht 4 hat einen Absorptionskoeffizienten α = 3,5 ˙ 10⁴ cm⁻¹ bei einer Wellenlänge von λ = 632 nm. Der Brechungsindex beträgt etwa 2,2. Die Transmission liegt bei einer Wellenlänge von λ = 632nm bei etwa 1 %.

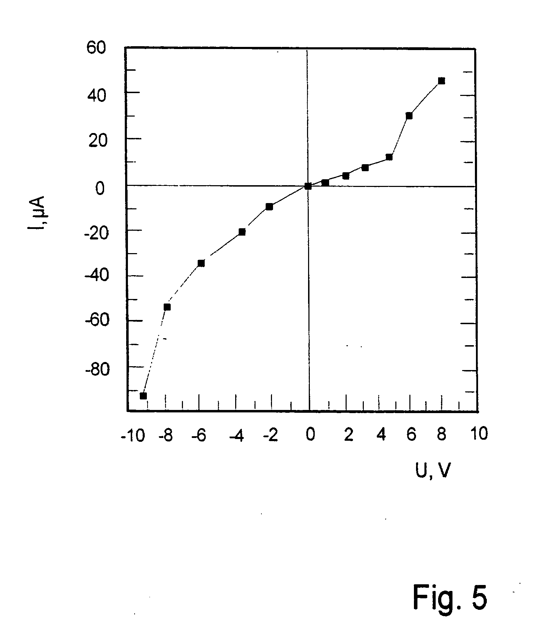

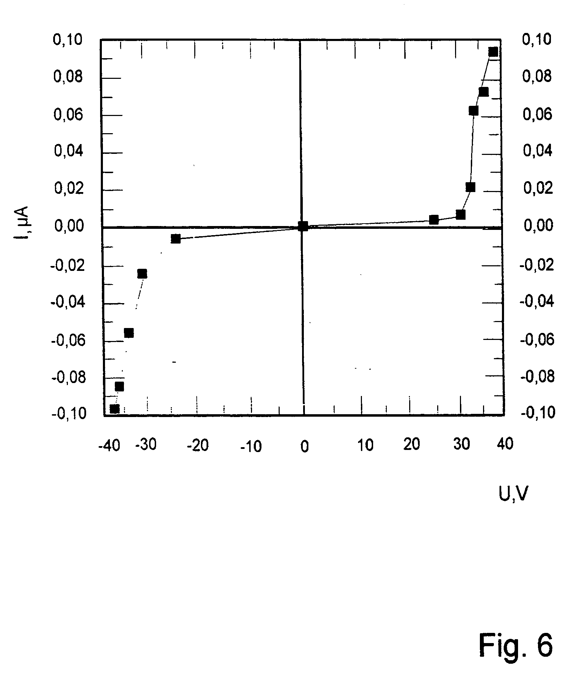

Aus der Strom-Spannungscharakteristik U (I), siehe Figuren 5 und 6, liest man ab, daß der spezifische Widerstand einer lichtblockierenden Schicht 4, bestehend aus amorphem, hydriertem Kohlenstoff α-C:H, in der Größenordnung von 10⁸ Ohm cm liegt, wenn die lichtblockierende Schicht 4 aus Azetylen-Argon nach dem CVD-Verfahren in einer Gleichstromentladung niedergeschlagen wird. Aus reinem Azetylen abgeschiedene, lichtblockierende Schichten 4 aus amorphem, hydriertem Kohlenstoff α-C:H haben einen höheren spezifischen Widerstand von 10¹² Ohm cm.

Im folgenden werden Beispiele für die Präparation von Kohlenstoff enthaltenden Filmen angegeben, die besonders gute Eigenschaften als lichtblockierende Schichten entsprechend der Erfindung gewährleisten.

### Beispiel 1

Zunächst wird auf einem Glassubstrat 1, das mit einer transparenten Elektrode (ITO) 2 beschichtet ist, eine photoleitende Schicht 3 aus amorphem, hydriertem Silizium α-Si:H abgeschieden. Durch kontinuierliches Ersetzen der Silane durch Azetylen in der Gasatmosphäre der CVD-Anlage wird die lichtblockierende Schicht 4 bei Gleichstromentladungen niedergeschlagen. Die aus amorphem, hydriertem Kohlenstoff α-C:H bestehende lichtblockierende Schicht 4 wurde aus einem Azetylen-Argongemisch bei einem Druck von 8˙10⁴ Torr und einer Entladungsleistung von 10 Watt mit einer Abscheiderate von 2 *Å*/*s* abgeschieden. Die so erzeugte lichtblockierende Schicht 4 aus amorphem, hydriertem Kohlenstoff α-C:H mit einer Dicke von 1 µm hat einen Absorptionskoeffizienten α = 5,2 ˙ 10⁴ cm⁻¹ und unterdrückt die optische Transmission der Schichtenfolge: Glas oder Quarzglassubstrat 1 + transparente Elektrode ITO 2 + photoleitende Schicht 3; α-Si:H + lichtblockierende Schicht 4; α-C:H um das 180-fache bei einer Wellenlänge von λ=632 nm. Der spezifische Widerstand der Schichten 2, 3 und 4 lag in der Größenordnung von 10⁸ Ohm cm.

### Beispiel 2

Die lichtblockierende Schicht 4 aus amorphem, hydriertem Kohlenstoff α-C:H wurde, wie im Beispiel 1, aus einer C₂H₂ + Argon Mischung bei einem Druck von 2·10⁻⁴ Torr und einer Entladungsleistung von 3,6 Watt mit einer Abscheiderate von 1,7 *Å*/*s* niedergeschlagen. Diese lichtblockierende Schicht 4 hatte bei 0,6 µm Dicke einen Absorptionskoeffizienten α = 5,4 ˙ 10⁴ m⁻¹. Eine 30-fache Lichtunterdrückung erfolgte durch die Schicht bei einer Wellenlänge λ = 632 nm. Der spezifische Widerstand der Schichtenfolge transparente Elektrode ITO 2 + lichtblockierende Schicht 4 aus amorphem, hydriertem Kohlenstoff α-C:H + dielektrischer Spiegel 5 lag in der Größenordnung von 10⁸ Ohm cm.

### Beispiel 3

Die lichtblockierende Schicht 4 aus amorphem, hydriertem Kohlenstoff α-C:H wurde, wie in Beispiel 1, aus einer C₂H₂ + Argon Mischung bei einem Druck von 2 ˙ 10⁻³ Torr und einer Entladungsleistung von 3,6 Watt mit einer Abscheiderate 1 *Å*/*s* niedergeschlagen. Die erhaltene lichtblockierende Schicht 4 aus amorphem, hydriertem Kohlenstoff α-C:H hat bei einer Dicke von 0,5 µm einen Absorptionskoeffizienten von α = 2 ˙ 10⁵ cm⁻¹ Dabei wird eine 530-fache Lichtunterdrückung der Schichtenfolge Glassubstrat 1 + transparente Elektrode ITO 2 + photoleitende Schicht 3 aus α-Si:H + lichtblockierende Schicht 4 aus α-C:H bei einer Wellenlänge λ = 632 nm erreicht. Der spezifische Widerstand der Struktur transparente Elektrode ITO 2 + lichtblockierende Schicht aus amorphem, hydrierten Kohlenstoff α-C:H + Metall lag in der Größenordnung von 10⁷ Ohm cm.

### Beispiel 4

Die lichtblockierende Schicht 4 wurde durch Deposition einer Schicht aus amorphem, hydriertem Kohlenstoff α-C:H auf einer Schichtenfolge, bestehend aus Glassubstrat 1, einer transparenten Elektrode ITO 2 und einer photoleitenden Schicht 3 aus amorphen, hydrierten Siliziumkarbid α-Si:C:H, hergestellt. Die lichtblockierende Schicht 4 wurde aus reinem Azetylen bei einem Druck von 7 · 10⁻⁴ Torr und einer Entladungsleistung bei 5,4 Watt mit einer Abscheiderate von 2 *Å*/*s* niedergeschlagen. Die lichtblockierende Schicht 4, bestehend aus amorphem, hydriertem Kohlenstoff α-C:H der Dicke 0,9 µm, reduzierte die optische Transmission der Schichtenfolge Glassubstrat 1 + transparente Elektrode ITO 2 + photoleitende Schicht 3 aus α-Si:H + lichtblockierende Schicht 4 aus α-C:H auf das 250-fache bei einer Wellenlänge von λ =632 nm. Der spezifische Widerstand der Struktur transparente Elektrode ITO 2 + lichtblockierende Schicht 4 aus α-C:H + dielektrischer Spiegel 5 lag in der Größenordnung von 10¹¹ Ohm cm.

### Beispiel 5

Die aus amorphem, hydriertem Kohlenstoff α-C:H bestehende lichtblockierende Schicht 4 wurde aus reinem Azetylen, wie im Beispiel 4, bei einem Druck von 1 · 10⁻⁴ Torr und einer Entladungsleistung von 3,6 Watt mit der Abscheiderate 3,4 *Å*/*s* niedergeschlagen. Die 1,1 µm dicke lichtblockierende Schicht 4 mit einem Absorptionskoeffizienten von α = 4 ˙ 10⁴ cm-1 reduzierte die optische Transmission der Schichtenfolge Glasubstrat 1 + transparente Elektrode ITO 2 + photoleitende Schicht aus α-Si:C:H + lichtblockierende Schicht 4 aus α-C:H auf das 50-fache bei einer Wellenlänge von λ=632 nm. Der spezifische Widerstand der Struktur transparente Elektrode 2 + lichtblockierende Schicht aus α-C:H + dielektrischer Spiegel 5 lag in der Größenordnung von 10¹² Ohm cm.

### Beispiel 6

Die aus amorphem, hydriertem Kohlenstoff α-C:H bestehende lichtblockierende Schicht 4 wurde aus reinem Azetylen, wie im Beispiel 4, bei einem Druck von 7˙10⁻⁴ Torr und einer Entladungsleistung von 3,4 Watt bei einer Abscheiderate von 0,9 *Å*/*s* niedergeschlagen. Die lichtblockierende Schicht 4 der Dicke 0,5 µm mit einem Absorptionskoeffizienten von α = 8 ˙ 10⁴ cm⁻¹ reduzierte die optische Transmission der Schichtenfolge: Glassubstrat 1 + transparente Elektrode ITO 2 + photoleitende Schicht 3 aus α-Si:C:H + lichtblockierende Schicht aus α-C:H um das 50-fache bei einer Wellenlänge von λ=632 nm. Der spezifische Widerstand der Struktur transparente Elektrode ITO 2 + lichtblockierende Schicht 4 aus α-C:H + dielektrischer Spiegel 5 lag in der Größenordnung von 10¹¹ Ohm cm.

### Beispiel 7

Die aus amorphem, hydriertem Kohlenstoff α-C:H bestehende lichtblockierende Schicht 4 wurde aus reinem Azetylen, wie im Beispiel 4, bei einem Druck von 4˙10⁻⁴ Torr und einer Entladungsleistung von 4,8 Watt mit einer Abscheiderate von 1 *Å*/*s* niedergeschlagen. Die so erzeugte lichtblockierende Schicht 4 mit einer Dicke von 0,5 µm und einem Absorptionskoeffizienten von α = 1 · 10⁵ cm⁻¹ reduzierte die optische Transmission der Schichtenfolge transparente Elektrode ITO 2 + photoleitende Schicht 3 aus α-Si:C:H + lichtblockierende Schicht 4 aus α-C:H auf das 150-fache bei einer Wellenlänge von λ=632 nm. Anschließend wurde zusätzlich ein praktisch transparenter Film aus amorphem, hydriertem Kohlenstoff α-C:H von nur 100 nm Dicke auf der als lichtblokkierende Schicht 4 ausgebildeten, optisch schwarzen α-C:H Schicht von 0,5 µm Dicke niedergeschlagen. Diese transparente, aus amorphem, hydriertem Kohlenstoff α-C:H bestehende Schicht wurde aus reinem Azetylen unter einem Druck von 2˙10⁻³ Torr bei einer Entladungsleistung von 0,6 Watt mit einer Abscheiderate von 1,7 *Å*/*s* aufgebracht. Der spezifische Widerstand der Struktur: transparente Elektrode ITO 2 + photoleitende Schicht 3 + lichtblockierende Schicht 3 aus α-C:H mit zusätzlich aufgebrachter transparenter Schicht aus α-C:H + dielektrischer Spiegel 5 steigt auf einen Wert in der Größenordnung von 10¹³ Ohm an.

Aus diesen Beispielen folgt, daß Kohlenstoff enthaltende schwarze Schichten auf der Grundlage von amorphem Kohlenstoff α-C und amorphem, hydriertem Kohlenstoff α-C:H eine sehr brauchbare lichtblockierende Schicht 4 für OASLMs abgeben. Diese Schichten ermöglichen eine deutliche Absorption im sichtbaren Spektralbereich (400nm bis 1000nm) bei geringer Dicke (0,1 µm bis 2,0µm) und hohem spezifischen Widerstand (10⁷ bis 10¹³ Ωcm). Mittels der nach dem erfindungsgemäßen Verfahren hergestellten Schichten ist es möglich, OASLM mit viellagigen Schichtenfolgen herzustellen.

### Bezugszeichenaufstellung

- 1: Trägerschicht aus Glas- bzw. Quarzglassubstrat
- 2: transparente Elektrode/ITO
- 3: photoleitende Schicht
- 4: lichtblockierende Schicht
- 5: dielektrischer Spiegel
- 6: orientierende Schicht für den Flüssigkristall
- 7: Flüssigkristall
- α: Absorptionskoeffizient
- α-C: amorpher Kohlenstoff
- α-C:H: amorpher hydrierter Kohlenstoff
- α-Si:C:H: amorphes hydriertes Siliziumkarbid
- λ: Wellenlänge des Lichtes
- OASLM: Optisch adressierbarer, ortsauflösender Lichtmodulator

## Patentansprüche

1. Verfahren zum Aufbringen einer lichtblockierenden Schicht zwischen photoleitender Schicht und Spiegel bei der Herstellung eines optisch adressierbaren ortsauflösenden Lichtmodulators OASLM unter Anwendung des CVD-Verfahrens,
wobei das Aufbringen der lichtblockierenden Schicht (4) und das Aufbringen der photoleitenden Schicht (3) in einem gemeinsamen Verfahrensschritt erfolgen, bei dem sowohl die Dicke und Zusammensetzung der auf eine transparente Elektrode (2) aufzubringenden photoleitenden Schicht (3) als auch die Dicke und Zusammensetzung der auf die photoleitende Schicht (3) aufzubringenden lichtblockierenden Schicht (4) durch eine zeitbezogene Änderung der Variation der Gaszusammensetzung während des Abscheidungsprozesses bestimmt werden, und bei dem in einem ersten Verfahrensschritt auf einem Glassubstrat (1), das mit der transparenten Elektrode (2) beschichtet ist, eine photoleitende Schicht (3) aus amorphem hydriertem Silizium abgeschieden wird, **dadurch gekennzeichnet,**
**dass** in der aus Argon bestehenden Gasatmosphäre der CVD-Anlage in einem kontinuierlichen Prozess Silane durch Kohlenwasserstoffe ersetzt werden, und dass sich bei Gleichstromentladungen auf der photoleitenden Schicht (3) eine lichtblockierende Schicht (4) aus reinem Kohlenstoff niederschlägt, so dass im Resultat eine aus photoleitender Schicht (3) und lichtblockierender Schicht (4) bestehende Schichtenfolge mit den gewünschten Widerständen entsteht.

2. Verfahren nach Anspruch 1 **dadurch gekennzeichnet, daß** nach Aufbringen einer photoleitenden Schicht (3) aus amorphem hydriertem Silizium α-Si:H in der Gas-atmosphäre der CVD-Anlage bei einem Druck von 0.107 Pa (8 x 10⁻⁴ Torr) die Silane der Gasatmosphäre kontinuierlich durch Azetylen ersetzt werden, wobei auf der photoleitenden Schicht (3) bei Gleichstromentladungen mit einer Entladungsleistung von 10 Watt und einer Abscheidungsrate von 0.2 nm/s (2 Å/s) eine lichtblockierende Schicht (4) aus amorphem hydriertem Kohlenstoff α-C:H mit einer Dicke von 1µm und einem Absorptionskoeffizienten α = 5,2 x 10⁴ cm⁻¹ abgeschieden wird.

3. Verfahren nach Anspruch 1, **dadurch gekennzeichnet, daß** bei einem Druck von 26.7 mPa (2 x 10⁻⁴ Torr) und einer Entladungsleistung von 3,6 Watt bei einer Abscheidungsrate von 0.17 nm/s (1,7 Å/s) auf der photoleitenden Schicht (3) eine lichtblockierende Schicht (4) von 0,6µm Dicke und einem Absorptionskoeffizienten von α = 5,2 x 10⁴ cm⁻¹ abgeschieden wird.

4. Verfahren nach Anspruch 1, **dadurch gekennzeichnet, daß** bei einem Druck von 267 mPa (2 x 10⁻³ Torr) und einer Entladungsleistung von 3,6 Watt bei einer Abscheidungsrate von 0.1 nm/s (1 Å/s) auf der photoleitenden Schicht (3) eine lichtblockierende Schicht aus amorphem hydriertem Kohlenstoff α-C;H mit einer Dicke von 0,5µm und einem Absorptionskoeffizienten von α= 2 x 10⁵ cm⁻¹ abgeschieden wird.

5. Verfahren nach Anspruch 1, **dadurch gekennzeichnet, daß** nach Aufbringen einer photoleitenden Schicht (3) aus amorphem hydriertem Siliziumkarbid α-Si;C;H nach Erreichen einer aus reinem Azetylen bestehenden Gasatmosphäre bei einem Druck von 93.3 mPa (7 x 10⁻⁴ Torr) auf der photoleitenden Schicht (3) bei Gleichstromentladungen mit einer Entladungsleistung von 5,4 Watt bei einer Abscheidungsrate von 0.2 nm/s (2Å/s) eine lichtblockierende Schicht (4) aus amorphem hydriertem Kohlenstoff α-C:H mit einer Dicke von 0,9 µm und einer Transmission der Schichtenfolge von 1/250 abgeschieden wird.

6. Verfahren nach Anspruch 1, **dadurch gekennzeichnet, daß** bei einem Druck von 13.3 mPa (1 x 10⁻⁴ Torr) und einer Entladungsleistung von 3,6 Watt bei einer Abscheidungsrate von 0.34 nm/s (3,4 Å/s) auf der photoleitenden Schicht (3) eine lichtblockierende Schicht von 1,1µm Dicke mit einem Absorptionskoeffizienten von α= 4 x 10⁴ cm⁻¹ abgeschieden wird.

7. Verfahren nach Anspruch 1, **dadurch gekennzeichnet, daß** bei einem Druck von 93.3 mPa (7 x 10⁻⁴ Torr) und einer Entladungsleistung von 3,4 Watt bei einer Abscheidungsrate von 0.09 nm/s (0,9 Å/s) auf der photoleitenden Schicht (3) eine lichtblockierende Schicht von 0,5µm Dicke mit einem Absorptionskoeffizienten von α= 8 x 10⁴ cm⁻¹ abgeschieden wird.

8. Verfahren nach Anspruch 1, **dadurch gekennzeichnet, daß** bei einem Druck von 53.3 mPa (4 x 10⁻⁴ Torr) und einer Entladungsleistung von 4,8 Watt bei einer Abscheidungsrate von 0.1 nm/s (1 Å/s) auf der photoleitenden Schicht (3) eine lichtblockierende Schicht von 0,5µm Dicke mit einem Absorptionskoeffizienten von α= 1 x 10⁵ cm⁻¹ abgeschieden wird.

9. Verfahren nach Anspruch 8, **dadurch gekennzeichnet, daß** bei einer reinen Azetylenatmosphäre unter einem Druck von 267 mPa (2 x 10⁻³ Torr) bei einer Entladungsleistung von 0,6 Watt und einer Abscheidungsrate von 0.17 nm/s (1,7Å/s) auf die lichtblockierende Schicht (4) eine transparente Schicht von 100nm Dicke aus amorphem hydriertem Kohlenstoff α-C:H abgeschieden wird.

## Claims

1. Method for applying a light-blocking layer between a photoconductive layer and a mirror during the manufacture of an optically addressed spatial light modulator OASLM using the CVD process, wherein the application of the light-blocking layer (4) and the application of the photoconductive layer (3) take place in a common process step in which both the thickness and composition of the photoconductive layer (3) to be applied to a transparent electrode (2) as well as the thickness and composition of the light-blocking layer (4) to be applied to the photoconductive layer (3) are determined by a time-related change in the variation of the gas composition during the deposition process, and in which a photoconductive layer (3) of amorphous hydrated silicon is deposited in a first process step onto a glass substrate (1) that has been coated with the transparent electrode (2), **characterized in that**
in the CVD system's gas atmosphere consisting of argon, silanes are replaced in a continuous process by hydrocarbons, and **in that** a light-blocking layer (4) of pure carbon is deposited on the photoconductive layer (3) in the presence of direct current discharges, with the result that a layer sequence consisting of the photoconductive layer (3) and the light-blocking layer (4) is produced with the desired resistances.

2. Method according to claim 1, **characterized in that**, after application of a photoconductive layer (3) of amorphous hydrated silicon α-Si:H in the gas atmosphere of the CVD system at a pressure of 0.107 Pa (8 x 10⁴ Torr), the silanes of the gas atmosphere are continuously replaced by acetylene, wherein a light-blocking layer (4) of amorphous hydrated carbon α-C:H with a thickness of 1 µm and an absorption coefficient α=5.2 x 10⁴ cm⁻¹ is deposited on the photoconductive layer (3) in the presence of direct current discharges with a discharge power of 10 watts and a deposition rate of 0.2 nm/s (2 Å/s).

3. Method according to claim 1, **characterized in that**, at a pressure of 26.7 mPa (2 x 10⁻⁴ Torr) and a discharge power of 3.6 watts, and at a deposition rate of 0.17 nm/s (1.7 Å/s), a light-blocking layer (4) with a thickness of 0.6 µm and an absorption coefficient α=5.2 x 10⁴ cm⁻¹ is deposited on the photoconductive layer (3).

4. Method according to claim 1, **characterized in that**, at a pressure of 267 mPa (2 x 10⁻³ Torr) and a discharge power of 3.6 watts, and at a deposition rate of 0.1 nm/s (1 Å/s), a light-blocking layer of amorphous hydrated carbon α-C:H with a thickness of 0.5 µm and an absorption coefficient α=2 x 10⁵ cm⁻¹ is deposited on the photoconductive layer (3).

5. Method according to claim 1, **characterized in that**, after application of a photoconductive layer (3) of amorphous hydrated silicon carbide α-Si:C:H, once a gas atmosphere consisting of pure acetylene has been achieved at a pressure of 93.3 mPa (7 x 10⁻⁴ Torr), a light-blocking layer (4) of amorphous hydrated carbon α-C:H with a thickness of 0.9 µm and a transmission of the layer sequence of 1/250 is deposited on the photoconductive layer (3) in the presence of direct current discharges with a discharge power of 5.4 watts and a deposition rate of 0.2 nm/s (2 Å/s).

6. Method according to claim 1, **characterized in that**, at a pressure of 13.3 mPa (1 x 10⁻⁴ Torr) and a discharge power of 3.6 watts, and at a deposition rate of 0.34 nm/s (3.4 Å/s), a light-blocking layer with a thickness of 1.1 µm and an absorption coefficient α=4 x 10⁴ cm⁻¹ is deposited on the photoconductive layer (3).

7. Method according to claim 1, **characterized in that**, at a pressure of 93.3 mPa (7 x 10⁻⁴ Torr) and a discharge power of 3.4 watts, and at a deposition rate of 0.09 nm/s (0.9 Å/s), a light-blocking layer with a thickness of 0.5 µm and an absorption coefficient α=8 x10⁴ cm⁻¹ is deposited on the photoconductive layer (3).

8. Method according to claim 1, **characterized in that**, at a pressure of 53.3 mPa (4 x 10⁻⁴ Torr) and a discharge power of 4.8 watts, and at a deposition rate of 0.1 nm/s (1 Å/s), a light-blocking layer with a thickness of 0.5 µm and an absorption coefficient α=1 x 10⁵ cm⁻¹ is deposited on the photoconductive layer (3).

9. Method according to claim 8, **characterized in that**, in a pure acetylene atmosphere at a pressure of 267 mPa (2 x 10⁻³ Torr) at a discharge power of 0.6 watts and a deposition rate of 0.17 nm/s (1.7 Å/s), a transparent layer of 100 nm thickness of amorphous hydrated carbon α-C:H is deposited on the light-blocking layer (4).

## Revendications

1. Procédé pour appliquer une couche de blocage de la lumière entre une couche photoconductrice et un miroir lors de la fabrication d'un modulateur spatial de lumière à adressage optique OASLM en utilisant le procédé CVD,
l'application de la couche de blocage de la lumière (4) et l'application de la couche photoconductrice (3) s'effectuant dans une étape commune du procédé où l'épaisseur et la composition de la couche photoconductrice (3) à appliquer sur une électrode (2) transparente ainsi que l'épaisseur et la composition de la couche de blocage de la lumière (4) à appliquer sur la couche photoconductrice (3) sont déterminées par une modification en fonction du temps de la variation de la composition du gaz pendant le processus de déposition, et où, dans une première étape du procédé, une couche photoconductrice (3) en silicium amorphe hydrogéné est déposée sur un substrat de verre (1) revêtu de l'électrode (2) transparente,
**caractérisé en ce que**,
sous atmosphère gazeuse constituée d'argon de l'installation CVD, des silanes sont remplacés par des hydrocarbures dans un processus continu et une couche de blocage de la lumière (4) en hydrocarbure pur se dépose sur la couche photoconductrice (3) par décharges de courant continu, de manière à obtenir une succession de couches composée de la couche photoconductrice (3) et de la couche de blocage de la lumière (4) et ayant les résistances souhaitées.

2. Procédé selon la revendication 1, **caractérisé en ce que**, après l'application d'une couche photoconductrice (3) de silicium amorphe hydrogéné α -Si:H dans l'atmosphère gazeuse de l'installation CVD, les silanes de l'atmosphère gazeuse sont continuellement remplacés par de l'acétylène à une pression de 0,107 Pa (8 x 10⁻⁴ torrs), une couche de blocage de la lumière (4) en carbone amorphe hydrogéné α -C:H d'une épaisseur de 1 µm et d'un coefficient d'absorption α = 5,2 x 10⁴ cm⁻¹ étant déposée sur la couche photoconductrice (3) par décharges de courant continu d'une puissance de décharge de 10 watts, à une vitesse de déposition de 0,2 nm/s (2 Å/s).

3. Procédé selon la revendication 1, **caractérisé en ce qu'**une couche de blocage de la lumière (4) d'une épaisseur de 0,6 µm et d'un coefficient d'absorption de α = 5,2 x 10⁴ cm⁻¹ est déposée sur la couche photoconductrice (3) à une pression de 26,7 mPa (2x10⁻⁴ torrs), à une puissance de décharge de 3,6 watts et à une vitesse de déposition de 0,17 nm/s (1,7 Å /s).

4. Procédé selon la revendication 1, **caractérisé en ce qu'**une couche de blocage de la lumière (4) en carbone amorphe hydrogéné α-C:H d'une épaisseur de 0,5 µm et d'un coefficient d'absorption de α = 2 x 10⁵ cm⁻¹ est déposée sur la couche photoconductrice (3) à une pression de 267 mPa (2 x 10-³ torrs), à une puissance de décharge de 3,6 watts et à une vitesse de déposition de 0,1 nm/s (1 Å /s).

5. Procédé selon la revendication 1, **caractérisé en ce que**, après l'application d'une couche photoconductrice (3) de carbure de silicium amorphe hydrogéné α -Si ;C;H après avoir obtenu une atmosphère gazeuse d'acétylène pur, une couche de blocage de la lumière (4) en carbone amorphe hydrogéné α -C:H d'une épaisseur de 0,9 µm et d'une transmission de la succession de couches de 1/250 est déposée sur la couche photoconductrice (3) à une pression de 93,3 mPa (7 x 10⁻⁴ torrs), par des décharges de courant continu d'une puissance de décharge de 5,4 watts, et à une vitesse de déposition de 0,2 nm/s (2 Å /s).

6. Procédé selon la revendication 1, **caractérisé en ce qu'**une couche de blocage de la lumière d'une épaisseur de 1,1 µm et d'un coefficient d'absorption de α = 4 x 10⁴ cm⁻¹ est déposée sur la couche photoconductrice (3) à une pression de 13,3 mPa (1 x 10⁻⁴ torrs), à une puissance de décharge de 3,6 watts, et à une vitesse de déposition de 0,34 nm/s (3,4 Å /s).

7. Procédé selon la revendication 1, **caractérisé en ce qu'**une couche de blocage de la lumière d'une épaisseur de 0,5 µm et d'un coefficient d'absorption de α = 8 x 10⁴ cm⁻¹ est déposée sur la couche photoconductrice (3) à une pression de 93,3 mPa (7 x 10⁻⁴ torrs), à une puissance de décharge de 3,4 watts et à une vitesse de déposition de 0,09 nm/s (0,9 Å /s).

8. Procédé selon la revendication 1, **caractérisé en ce qu'**une couche de blocage de la lumière d'une épaisseur de 0,5 µm et d'un coefficient d'absorption de α = 1 x 10⁵ cm⁻¹ est déposée sur la couche photoconductrice (3) à une pression de 53,3 mPa (4 x 10⁻⁴ torrs), à une puissance de décharge de 4,8 watts et à une vitesse de déposition de 0,1 nm/s (1 Å/s).

9. Procédé selon la revendication 8, **caractérisé en ce qu'**une couche transparente en carbone amorphe hydrogéné α -C:H d'une épaisseur de 100 nm est déposée sur la couche de blocage de la lumière (4) dans une atmosphère d'acétylène pur à une pression de 267 mPa (2 x 10⁻³ torrs), à une puissance de décharge de 0,6 watts et à une vitesse de déposition de 0,17 nm/s (1,7 Å/s).
